# EUROPÄISCHE PATENTSCHRIFT

(11) **EP 1 323 589 B1**
(45) Veröffentlichungstag und Bekanntmachung des Hinweises auf die Patenterteilung: **27.12.2006**
(21) Anmeldenummer: 02027538.4
(22) Anmeldetag: 09.12.2002
(51) Int. Cl.: B60R 16/02, B60H 1/00

(54) **Heizungs- oder Klimaanlage, insbesondere für ein Kraftfahrzeug, mit einer Folienleiterbahn**
Heating or cooling device for a vehicle with flexible flat cable
Système de chauffage ou de climatisation de véhicule avec câble conducteur en feuille mince

(30) Priorität: 21.12.2001 DE 10163201
(43) Veröffentlichungstag der Anmeldung: 02.07.2003
(73) Patentinhaber: Behr GmbH & Co. KG, 70469 Stuttgart (DE)
(72) Erfinder: Denk, Walter, 71254 Ditzingen (DE); Ghussein, Luay, Dipl.-Ing., 70374 Stuttgart (DE); Kirschner, Volker, Dipl.-Ing.(FH), 75417 Mühlacker (DE); Kreuzer, Walter, 71229 Leonberg (DE); Liermann, Andreas, Dipl.Ing.(FH), 67117 Limburgerhof (DE); Lochmahr, Karl, Dipl.-Ing.(FH), 71665 Vaihingen (DE); Otto, Jürgen,Dipl.-Ing.(FH), 75428 Illingen (DE); Pubrl, Harald,Dipl.-Ing.(FH), 70437 Stuttgart (DE); Schmadl, Dieter, Dipl.-Ing., 71672 Marbach (DE); Voigt, Klaus, Dipl.-Ing., 74321 Bietigheim-Bissingen (DE); Waibel, Klaus, 70806 Kornwestheim (DE)
(74) Vertreter: Grauel, Andreas

(56) Entgegenhaltungen:
- EP-A- 0 149 907
- EP-A- 0 977 335
- EP-A- 1 078 786
- DE-A- 10 035 851
- DE-A- 10 039 576
- FR-A- 2 795 832
- US-A- 5 270 972
- US-A1- 2001 005 083

## Beschreibung

Die Erfindung betrifft insbesondere eine Heizungs- oder Klimaanlage für ein Kraftfahrzeug mit einer Folienleiterbahn gemäß dem Oberbegriff des Anspruchs 1.

Heutige Fahrzeugklimaanlagen werden über ein Steuergerät gesteuert bzw. geregelt, das als bauliche Einheit mit einer Bedieneinheit, die in der Mittelkonsole bzw. in der Armaturentafel angeordnet ist, ausgebildet ist. Das Bedien- und Steuergerät weist Bedienelemente, wie Schalter, Taster, Drehknöpfe usw., auf, über die Benutzereinstellungen, wie gewünschte Temperatur, gewünschte Luftverteilung etc., eingebbar sind. Die eingegebenen Signale werden in dem Steuergerät elektronisch verarbeitet und über elektrische Verbindungen, in der Regel Rundleiter, dem Klimagerät, das ein Luftführungsgehäuse mit darin angeordneten Filter, Wärmetauscher, Luftstromsteuerelementen, Aktoren und gegebenenfalls Sensoren umfasst, zugeführt. Über einen Kabelbaum sind die elektrischen Komponenten des Klimageräts, wie Sensoren und Aktoren, beispielsweise Schrittverstellmotoren für die Luftstromsteuerelemente sowie das Gebläse, elektrisch miteinander verbunden.

Wichtige Faktoren bei der Konstruktion von Klimaanlagen sind einerseits der Bauraum den die Klimaanlage im Fahrzeug einnimmt und andererseits die Kosten zur Herstellung von Klimaanlagen. Heutzutage werden vermehrt Aktoren eingesetzt, um Luftklappen zu betätigen, sowie vermehrt Sensoren zur Überwachung verschiedenster Funktion, beispielsweise Überwachung von Temperaturen, beispielsweise der Verdampfertemperatur zur Vermeidung einer Verdampfervereisung, Überwachung von Luftstromgeschwindigkeiten, Überwachung der Luftgüte (Partikel, Schadstoffe, Geruchsstoffen), etc., eingesetzt. Die Aktoren und Sensoren bringen insgesamt einen erhöhten Verbindungsaufwand oder Verkabelungsaufwand und damit einhergehende Kosten mit sich. Der vermehrte Einsatz elektronischer Komponenten führt weiter zu einem sehr hohen Kommunikationsaufwand, z.B. über Bussysteme, so dass entsprechende Priorisierungen und Echtzeitbearbeitungen immer schwieriger werden und die Störanfälligkeit wächst.

Ferner ist aus der nachveröffentlichten DE 100 39 576 A1 bekannt, die Steuerelektronik unmittelbar in der Nähe des Luftführungsgehäuses anzuordnen. Damit ist die bauliche Einheit zwischen Bediengerät und Steuergerät aufgehoben und die Steuerelektronik von dem Bediengerät in bzw. an das Klimagehäuse verlagert, also dorthin verlagert, wo die Luft konditioniert und temperiert wird. Hierbei wird als Alternative zu herkömmlichen elektrischen Leitungen, d.h. Rundleitern, auch die Verwendung von Flachbandkabeln oder Folienleiterbahnen vorgeschlagen.

Des Weiteren zeigt die EP 1 078 786 A2 eine Fahrzeug-Klimaanlage mit einer Mehrzahl elektrischer Bauteile, wie einem Gebläseregler, Servomotoren und einem Verdampfertemperatursensor, die konzentrisch auf einer elektrischen Schaltkreisplatte, welche integral mit einer Verdampfergehäuseabdeckung ausgeformt ist, angeordnet sind. Eine entsprechende Verbindung mit den elektrischen Kabeln bzw. eines Kabelbaumes kann so sehr einfach gestaltet werden.

Es ist Aufgabe der Erfindung, eine eingangs genannte Heizungs- oder Klimaanlage weiter zu verbessern.

Diese Aufgabe wird gelöst durch eine Heizungs- oder Klimaanlage mit den Merkmalen des Anspruchs 1.

Erfindungsgemäß ist eine Heizungs- oder Klimaanlage für ein Kraftfahrzeug mit einem Luftführungsgehäuse vorgesehen, in und/oder an dem Komponenten der Anlage angeordnet sind, wobei die Komponenten Gebläse, gegebenenfalls Filter, wenigstens einen Wärmetauscher, Luftstromsteuerelemente, Aktoren und gegebenenfalls Sensoren umfassen und mit einer Steuerelektronik, in die von einer Bedieneinheit Steuersignale eingebbar sind und die Steuerelektronik über elektrische Leitungen mit wenigstens einigen der Komponenten der Anlage verbunden ist, wobei zumindest ein Teil der elektrischen Leitungen durch eine oder mehrere Folienleiterbahnen gebildet wird, bspw. einer FPC (flexible printed circuit - im folgenden wird unter FPC sowohl eine gedruckte Schaltung als auch eine entsprechend hergestellte Leitung verstanden) oder eines FFCs (flexible flat cable). Hierbei wird jede Folienleiterbahn durch mindestens eine Leitungen gebildet. Die erfindungsgemäße Heizungs- oder Klimaanlage weist ein Adressierungssystem in Form einer FPC (100) auf.

Alternativ erfolgt die Adressierung mittels der Masse-Leitung, wobei die Adressleitungen selektiv mit der Masse-Leitung in Form einer FPC verbunden sind. Die Verwendung einer FPC bietet unter anderem die Vorteile, dass sie kostengünstig und zuverlässig ist.

Da die Verkabelung jetzt erheblich kleiner und kompakter gebaut werden kann, wobei insbesondere auf Kabelbäume verzichtet werden kann, kann Bauraum geschaffen werden für andere Komponenten, beispielsweise Spracheingabemodul, CD-Spieler, Navigationsgerät oder dergleichen Geräte. Ferner lassen sich die einzelnen Leitungen der Folienleiterbahnen entsprechend der zu übertragenden Leistungen dimensionieren, so dass Material eingespart werden kann. Die Folienleiterbahnen können auf einfache, kostengünstige Weise direkt am Luftführungsgehäuse befestigt werden, bspw. mittels Kleben, Clipsen oder Klemmen, so dass keine Schlaufen o.ä. entstehen und der Bauraum optimal ausgenutzt werden kann. Die Unterbringung dezentraler Elektronikbaugruppen wird erheblich vereinfacht. Gegebenenfalls können Bereiche der Folienleiterbahn, auf der Aktoren, Sensoren oder andere elektrische Bauteile sitzen, durch einen Materialverbund verstärkt werden, so dass diese Bereiche starrflexibel oder starr sind.

Vorzugsweise weist die Folienleiterbahn drei Leitungen auf. Die Leitungen bilden die Plus-, Masse- und Daten-Leitung zur Ansteuerung von Busteilnehmern.

Ferner weist die elektrische Leitung, d.h. die Folienleiterbahn, mindestens eine Abzweigung und/oder eine Verbindung auf. Hierbei ist an einer Abzweigung vorzugsweise mindestens ein Busteilnehmer angeordnet, der seine Stromversorgung über die Plus-Leitung, die Daten über die Datenleitung erhält und dessen Codierung über die Masse-Leitung erfolgt.

Gemäß einer bevorzugten Ausführungsform weist die Folienleiterbahn eine Schutzvorrichtung auf. Sie dient zum Schutz vor Umwelteinflüssen und mechanischen Belastungen, insbesondere Zugbelastungen. Bevorzugt wird diese Schutzvorrichtung durch eine Abdeckung gebildet, welche zumindest einen Bereich der Folienleiterbahn überdeckt. Dabei kann die Abdeckung aus dem selben Werkstoff wie das Trägermaterial der Folienleiterbahn bestehen. Hierbei kann die Schutzvorrichtung durch einen Teil der Folienleiterbahn gebildet sein, in welchem keine Leitung(en) vorgesehen sind. Dabei kann der Teil der Folienleiterbahn, welcher die Schutzvorrichtung bildet, ein Teil der Folienleiterbahn sein, welcher im Ausgangszustand seitlich oder in Längsrichtung übersteht und welcher umgeschlagen und an der Folienleiterbahn befestigt wird. Die Befestigung kann mittels Crimpen, Piercen, Kleben, Löten, Schweißen, Siegeln o.ä. erfolgen.

Vorzugsweise ist die Schutzvorrichtung im Bereich einer Abzweigung, einer Verbindung oder in einem mit mindestens einem zusätzlichen Element, d.h. bspw. einem elektrischen Bauteil, versehenen Bereich vorgesehen.

Vorzugsweise weist die Heizungs- oder Klimaanlage eine Verbindungsvorrichtung auf, mittels welcher die Folienleiterbahnen bspw. am Gehäuse der Heizungs- oder Klimaanlage befestigt werden. Dabei erfolgt die Befestigung bevorzugt lösbar.

Gemäß einer bevorzugten Ausführungsform weist die Verbindungsvorrichtung Vorsprünge auf, die mit Öffnungen zusammenwirken, d.h. beim Verbinden werden die Öffnungen über die Vorsprünge geschoben, wo sie infolge Form- und/oder Reibschluss gehalten werden. Bevorzugt sind die Vorsprünge direkt am Luftführungsgehäuse der Heizungs- oder Klimaanlage vorgesehen. Dabei können die Vorsprünge mit der Herstellung des Gehäuses hergestellt, aber auch nachträglich an der Oberfläche des Gehäuses angebracht werden. Die Öffnungen können bspw. nachträglich in die Folienleiterbahn gestanzt werden.

Vorzugsweise weist die Verbindungsvorrichtung Mittel auf, um eine positionierte Anbringung der Folienleiterbahn am Gehäuse zu ermöglichen. Diese Mittel können bspw. durch die Art der Öffnungen oder Vorsprünge gebildet werden.

Vorzugsweise sieht das Adressierungssystem einen Stecker vor, der mit Codierelementen zusammenwirkt, die außerhalb vom Stecker vorgesehen sind. Hierbei dienen die Codierelemente bevorzugt zur Unterbrechung des elektrischen Kontakts, alternativ können sie jedoch auch den elektrischen Kontakt herstellen.

Vorzugsweise weist das Adressierungssystem n Adressleitungen auf, wobei die Zahl der maximalen Busteilnehmer in einem entsprechenden System 2ⁿ ist.

Im folgenden wird die Erfindung anhand eines Ausführungsbeispiels unter Bezugnahme auf die Zeichnung im Einzelnen erläutert. In der Zeichnung zeigen:
- Fig. 1 und 2: Ausführungsformen einer erfindungsgemäßen Klimaanlage in zwei perspektivischen Darstellungen;
- Fig. 3 und 4: Anordnungsmöglichkeiten der Steuerelektronik und der Gebläseleistungselektronik an einem Gebläsemotorhalter;
- Fig. 5 bis 7: Blockschaltbilder zur Steuerung der Klimaanlage;
- Fig. 8 bis 11: Ausführungsformen von verschiedenen Abzweigungen und Verbindungen;
- Fig. 12 bis 16: Ausführungsformen von verschiedenen Schutzvorrichtungen;
- Fig. 17 eine: Verbindungsvorrichtung;
- Fig. 18 und 19: eine Steckverbindung mit Adressierungsmöglichkeiten; und
- Fig. 20 bis 23: verschiedene Adressierungssysteme.

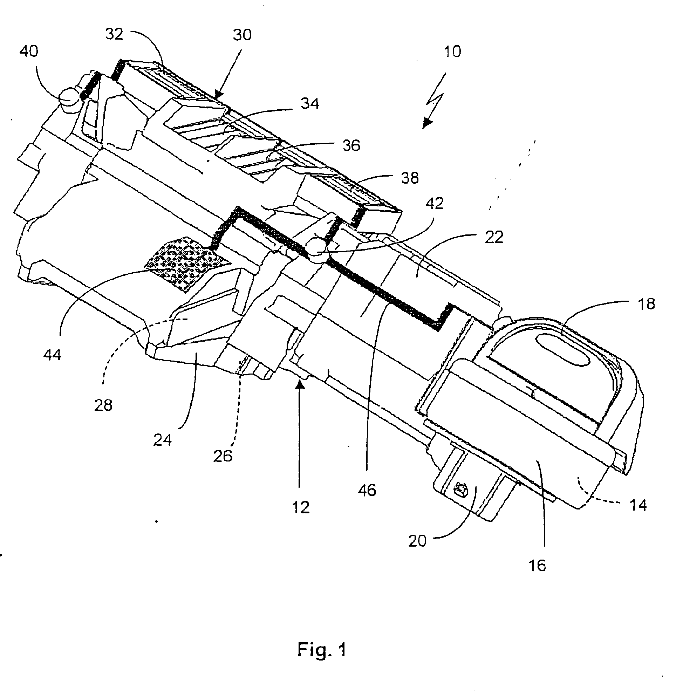

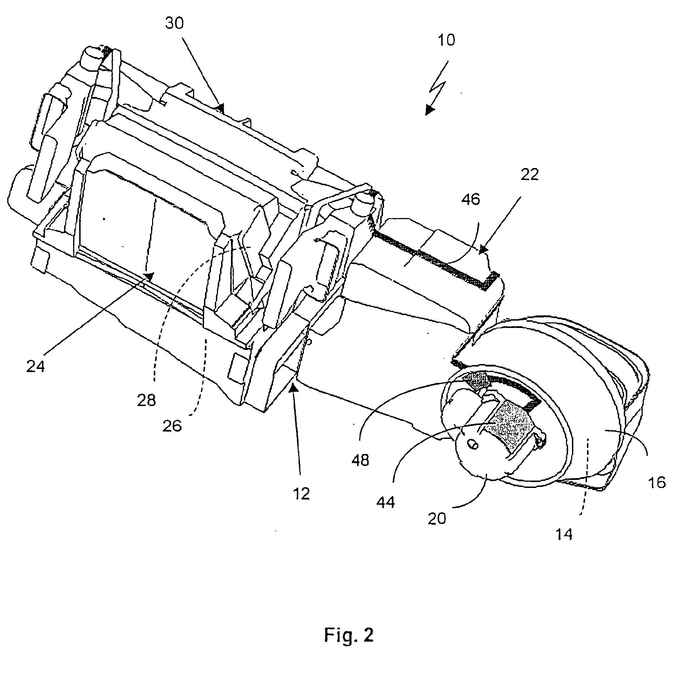

Eine erfindungsgemäße Klimaanlage 10 weist ein Luftführungsgehäuse 12 auf, in bzw. an dem verschiedene Komponenten der Klimaanlage angeordnet sind. In den Figuren 1 und 2 ist lediglich eine perspektivische Ansicht einer solchen Klimaanlage dargestellt, so dass die im Inneren des Luftführungsgehäuses 12 gelegenen Komponenten nicht erkennbar sind. Die Klimaanlage 10 ist in an sich bekannter Weise aufgebaut. Ein Gebläse 14 ist in einem Gebläsegehäuse 16, das ein Laufrad des Gebläses 14 umgibt, angeordnet. Luftstromseitig vor dem Gebläse 14 ist ein Luftansaugtrakt 18 angeordnet und ein Gebläsemotor 54 ist in einem Gebläsemotorhalter 20 gehalten. An das Gebläsegehäuse 16 schließt sich ein Filtergehäuse 22 an, in dem ein oder mehrere Filter zur Reinigung der geförderten Luft angeordnet sein können. An das Filtergehäuse 22 schließt sich ein Lufttemperiergehäuse 24 an, in dem ein Verdampfer 26 und ein Heizkörper 28 zur Kühlung und Aufheizung der Luft angeordnet sind. An das Lufttemperiergehäuse 24 schließt sich ein Luftverteilgehäuse 30 an, in dem die Luft auf die verschiedenen Luftauslässe 32, 34, 36 und 38 verteilt wird. Die Luftauslässe sind über Luftklappen, beispielsweise Jalousieklappen, verschließbar. Die einzelnen Luftklappen und auch die innerhalb des Lufttemperierungsgehäuses 24 und innerhalb des Luftverteilgehäuses 30 angeordneten und in den Figuren nicht sichtbaren Klappen sind über Aktoren, beispielsweise Schrittverstellmotoren, betätigbar. In den Fig. 1 und 2 sind lediglich zwei Schrittverstellmotoren 40 und 42 beispielhaft dargestellt.

Der Verdampfer 26 ist in nicht dargestellter Weise in einen Kältemittelkreis, bestehend aus über Kältemittelleitungen verbundenem Kältemittelverdichter, Kältemittelkondensator und Expansionsventil, eingebunden.

Weiter umfasst die Klimaanlage 10 eine Bedieneinheit 80, die in erreichbarer Nähe eines Benutzer des Fahrzeuges, vorzugsweise einer Instrumententafel oder einer Mittelkonsole, angeordnet ist und über die gewünschte Temperaturvorgaben und gewünschte Luftverteilungs- und Luftmengenvorgaben eingebbar sind. Die Bedieneinheit 80 ist über elektrische Leitungen, drahtlose Verbindung, wie z.B. über Funk und/oder Lichtleiter mit einer Steuerelektronik 44 verbunden, in der von der Bedieneinheit 80 kommende Steuersignale verarbeitet werden. Die Steuersignale von der Bedieneinheit 80 werden in der Steuerelektronik 44 verarbeitet und daraufhin die entsprechenden Komponenten der Klimaanlage 10 entsprechend angesteuert, wie im Näheren weiter unten beschrieben ist.

Die Steuerungselektronik 44 ist in unmittelbarer Nähe des Luftführungsgehäuses 12 angeordnet. In dem Ausführungsbeispiel nach Fig.1 ist die Steuerelektronik auf einer Außenseite des Luftführungsgehäuses 12 angeordnet. Die Steuerelektronik 44 kann beispielsweise eine starre Leiterplatte umfassen, die auf das Gehäuse 12 in geeigneter Weise durch Schrauben, Klipsen, Kleben oder dergleichen festlegbar ist. Bevorzugt umfasst die Steuerelektronik 44 eine flexible Leiterplatte, die sich der Gehäusekontur anpassen kann, wie dies in Fig. 1 und Fig. 2 angedeutet ist.

Alternativ könnte die Steuerelektronik 44 auch in anderen Bereichen des Luftführungsgehäuses 12 der Klimaanlage 10 angeordnet sein, beispielsweise an dem Luftverteilgehäuse 30, an dem Filtergehäuse 22 oder an dem Gebläsegehäuse 16.

In einer weiteren alternativen Ausgestaltung könnte die Steuerelektronik 44 bei der Herstellung des Luftführungsgehäuses 12 in eine Gehäusewand in einem Spritzgießprozess mit integriert, wie eingebracht beispielsweise eingespritzt werden.

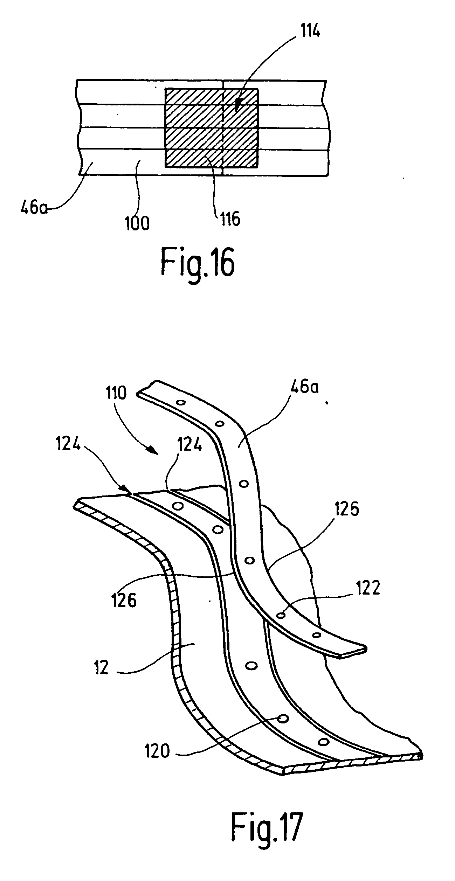

Sämtliche elektronischen Komponenten, die in oder an dem Luftführungsgehäuse 12 angeordnet sind, sind über elektrische Leitungen 46 miteinander verbunden, wobei die Leitungen 46 als Folienleiterbahnen 46a ausgebildet sind, die auf das Luftführungsgehäuse 12 aufklebbar sind oder mittels einer an späterer Stelle unter Bezugnahme auf Fig. 17 beschriebenen Verbindungsvorrichtung 110 mit dem Luftführungsgehäuse 12 verbunden werden können. Auf den Aufbau der Folienleiterbahnen 46a wird ebenfalls an späterer Stelle näher eingegangen.

Sämtliche Aktoren 40, 42 sowie etwaige Sensoren, wie beispielsweise ein Verdampfertemperatursensor, der die Lufttemperatur nach dem Verdampfer misst, sind derart ausgebildet, dass sie beim Einstecken in das Gehäuse 12 gleichzeitig mit den Leitungen 46 kontaktiert werden, so dass die Einstecköffnung in das Gehäuse 12 gleichzeitig einen Stecker zur Herstellung der elektrischen Kontakte darstellt. Andere Möglichkeiten zur Herstellung der elektrischen Kontakte sind möglich.

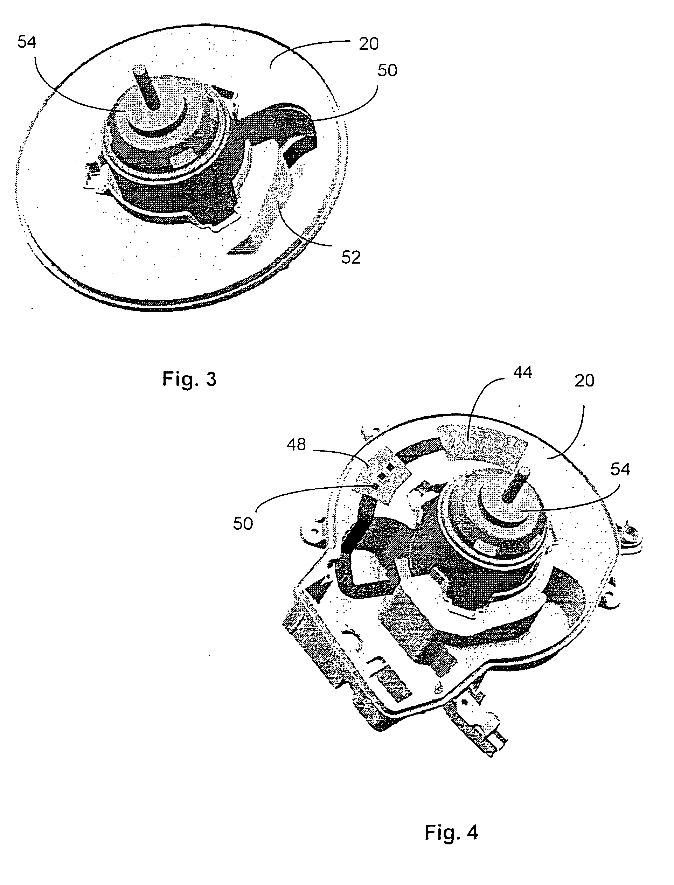

Eine vorteilhafte Anordnung der Steuerelektronik 44 ist in den Fig. 2, 3 und 4 dargestellt, bei der die Steuerelektronik 44 im Bereich des Gebläsegehäuses 16 angeordnet ist. In Fig. 2 ist eine erste Anordnung gezeigt, bei der die Steuerelektronik 44 an der Außenseite des Gebläsemotorhalters 20 angeordnet ist. Ebenfalls ist in Fig. 2 eine Gebläseleistungselektronik 48 zu erkennen, die zu kühlende Leistungstransistoren 50 umfasst, wobei die Leistungstransistoren 50 derart angeordnet sein sollten, dass sie in dem von dem Gebläse 14 geförderten Luftstrom hineinragen und dadurch gekühlt werden. In den Fig. 3 und 4 ist lediglich der Gebläsemotorhalter 20 mit einem darin angeordneten Gebläsemotor 54 dargestellt. Gemäß Fig. 3 ist die Steuerelektronik 44 zusammen mit der Gebläseleistungselektronik 48 und den zu kühlenden Leistungstransistoren 50 in einem Nebenluftansaugkanal 52 angeordnet. In Fig. 4 ist die Steuerelektronik 44 und die Gebläseleistungselektronik 48 getrennt voneinander auf der Innenseite des Gebläsemotorhalters 20 angeordnet.

In nicht näher dargestellten Ausführungsformen besteht die Steuerelektronik 44 aus einzelnen Untereinheiten, die separat an unterschiedlichen Stellen des Luftführungsgehäuses 12 der Klimaanlage 10 angeordnet sein können.

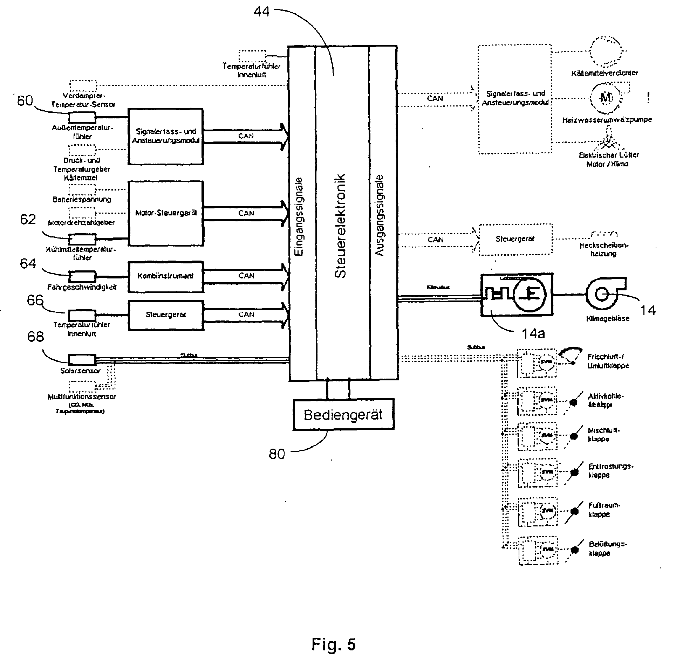

Die einzelnen Untereinheiten, die in ihrer Funktion weiter unten unter Bezugnahme auf die Fig. 5 bis 7 erläutert werden, können eine Gebläsesteuereinheit, eine Luftgütesteuereinheit, eine Verdampfertemperatursteuereinheit sowie eine Luftverteilsteuereinheit sein.

Die Figuren 5 bis 7 zeigen identische Blockschaltbilder zur Steuerung der erfindungsgemäßen Klimaanlage 10, wobei in den Figuren jeweils zu einer Untereinheit funktional zusammengehörende Elemente fett gedruckt dargestellt sind. Diese Zusammenhänge sind lediglich beispielhaft und könnten weitere Elemente und/oder Signale umfassen. Die unten beschriebenen Funktionsweisen sind ebenfalls nur beispielhaft. Weitere Funktionen der einzelnen Untereinheiten sind denkbar.

So umfasst gemäß Fig. 5 beispielsweise die Gebläsesteuereinheit ausgangsseitig das Gebläse 14 und einen Gebläseregler 14a, der selbstverständlich die Leistungselektronik 48 umfasst, sowie eingangsseitig einen Außentemperaturfühler 60, einen Kühlmitteltemperaturfühler 62, eine Fahrgeschwindigkeitsmesser 64, einen Innenraumtemperaturfühler 66 und einen Solarsensor 68, sowie entsprechende funktionale Bereiche der Steuerelektronik 44. Über die Bedieneinheit 80 kann die Gebläsestärke entweder manuell oder in einem einschaltbaren Automatikmodus von der Steuerelektronik eingestellt werden. Im Automatikmodus wird die Ansteuerung des Gebläses maßgeblich von der Differenz zwischen Innenraum-Solltemperatur und Innenraum-Isttemperatur bestimmt. Bei starker Abweichung wird die Gebläsestärke erhöht. Davon abweichend wird die Gebläsestärke reduziert, wenn beispielsweise die Kühlwassertemperatur unter 50°C beträgt und die Klimaanlage im Modus "Heizen" betrieben wird oder wenn die Fahrgeschwindigkeit erhöht wird. Die Gebläsestärke kann erhöht werden, wenn die Sonneneinstrahlung zunimmt. Weiter Abweichungen von der "normalen" Gebläseregelung wären denkbar, wenn beispielsweise eine bestimmte Klappenstellung eingestellt ist oder das Gebläse je nach Außentemperatur einen Offset erhält.

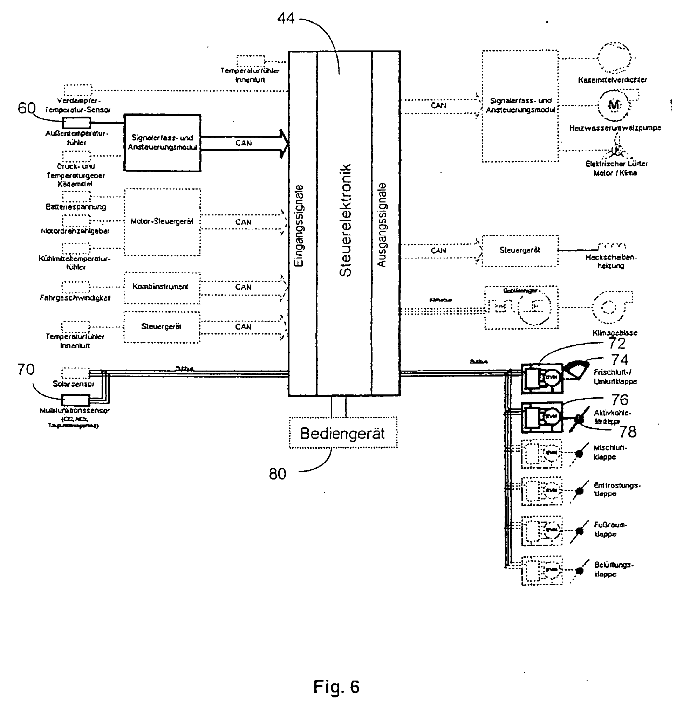

In Fig. 6 ist eine Luftgütesteuereinheit durch Fettdruck der entsprechenden Komponenten dargestellt, wobei diese Einheit den Außentemperaturfühler 60 sowie einen Multifunktionssensor 70, der beispielsweise Schadstoffe, wie CO, CO2, NOx, Schwebstoffe (Ruß, Staub), Geruchsstoffe detektiert und ausgangsseitig die Ansteuerung eines Aktors 72 für eine Frischluft-/Umluftklappe sowie einen Aktor 76 für eine Filterklappe 78 und entsprechende Elemente der Steuerelektronik 44 umfasst. Die Luftgütesteuereinheit kann in einem einschaltbaren Automatikmodus unabhängig von den Eingaben des Bediengerätes 80 arbeiten, so dass unabhängig von den Vorgaben durch das Bediengerät 80 stets eine optimale Luftgüte gewährleistet ist. In diesem Modus wird z.B. bei hohen Außentemperaturen der Umluftanteil variiert, um den Fahrgastraum schneller und mit weniger Kühlleistungsbedarf abkühlen zu können, ohne das im Fahrgastraum die Luftqualität beeinträchtigt ist. Bei hohen Schadstoffbelastungen der Außenluft wird in den Umluftbetrieb geschaltet. Eine Rückschaltung in den Frischluftbetrieb kann nach einer vorprogrammierten Zeitspanne automatisch in Abhängigkeit der Außentemperatur erfolgen.

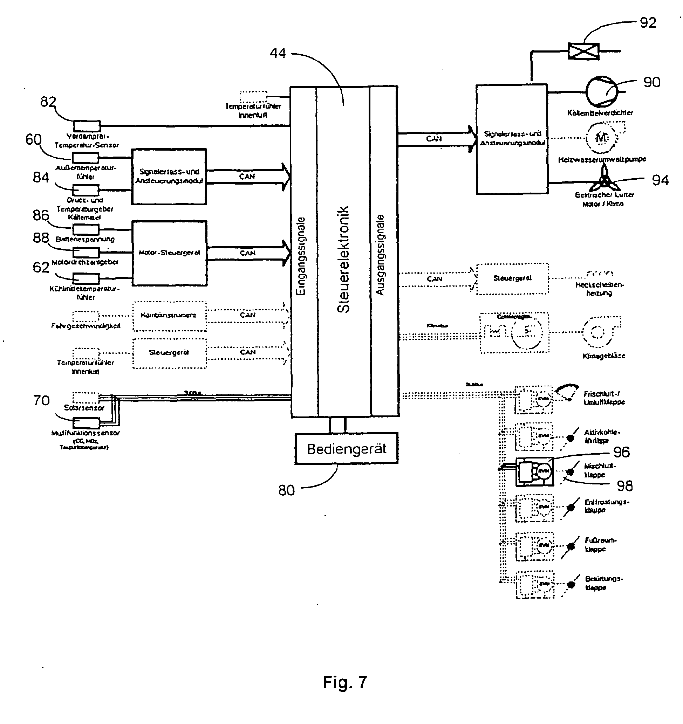

In Fig. 7 sind durch Fettdruck die Komponenten dargestellt, die funktional zu einer Verdampfertemperatursteuereinheit zusammenfassbar sind. Diese umfassen einen Verdampfertemperatursensor 82, den Außentemperaturfühler 60, einen Druck- und Temperaturgeber 84 für das Kältemittel, einen Batteriespannungssensor 86, einen Motordrehzahlgeber 88, den Kühlmitteltemperaturfühler 62 sowie den Multifunktionssensor, Schadstoffsensor 70. Ausgangsseitig umfasst die Verdampfertemperaturregelung den Kältemittelverdichter 90, gegebenenfalls ein thermostatisches Expansionsventil 92 und ein nicht dargestelltes Heizungsventil, einen elektrischen Lüfter 94, der Luft durch den Kondensator des Kältemittelkreises fördert, sowie einen Aktor 96, der eine Luftmischklappe 98 betätigt, die in dem Lufttemperierungsgehäuse 24 angeordnet ist. Wenn der Kühlbetrieb eingeschaltet ist, kann die Verdampfertemperaturregelung verschiedene Aufgaben erfüllen. Bei einer relativen Luftfeuchte von beispielsweise 0 bis 50 % wird die Mischluftklappe derart eingestellt, dass die Klimaanlage nicht in einem Reheatbetrieb betrieben wird. Bei einer relativen Luftfeuchte von beispielsweise 50 bis 85 % findet ein geringer Reheatbetrieb mit gleitender Verdampfertemperaturregelung zwischen beispielsweise 0 und 12°C statt und bei einer relativen Luftfeuchte von beispielsweise 85 bis 100 % findet voller Reheatbetrieb statt. Die Verdampfertemperatur wird auf einen minimalen Wert geregelt. Mit den zu der Verdampfertemperaturregelung gehörenden funktionalen Einheiten lässt sich auch eine Kältemittel-Füllstandsüberwachung durchführen, indem aus dem über den Geber 84 ermittelten Druck und Temperatur des Kältemittels nach dem Verdichter anhand einer in der Steuerelektronik 44 hinterlegten Kurve, der Kältemittelstand rechnerisch ermittelt und bei zu geringem Füllstand der Kühlbetrieb zum Schutz der Klimaanlage verlassen wird.

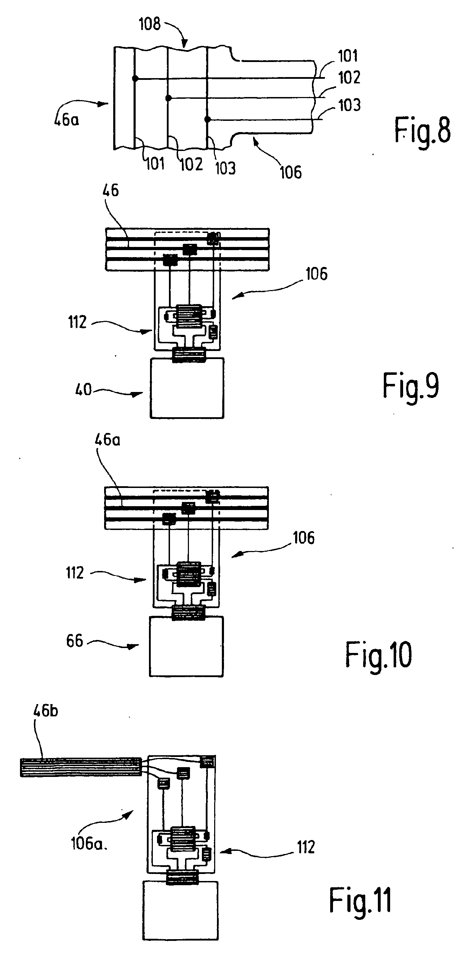

Fig. 8 zeigt eine der Folienleiterbahnen 46a der Klimaanlage 10 im Detail. Hierbei handelt es sich bei dieser ersten Ausführungsform um eine FPC 100 (flexible printed circuit - im folgenden wird dieser Begriff auch für entsprechend hergestellte Leitungen verwendet) mit drei Leitungen 101, 102 und 103. Die Leitungen 101, 102 und 103 bilden die Plus-, Daten- bzw. Masse-Leitung. , wobei über die Plus-Leitung die Stromversorgung, über die Daten-Leitung. Hierbei erfolgt die Stromversorgung über die Plusleitung, die Daten zur Ansteuerung von Busteilnehmern werden über die Datenleitung übertragen und die Adressen, auf die an späterer Stelle Bezug genommen wird, werden über die Masse-Leitung definiert.

Gemäß der dargestellten Ausführungsform hat die Folienleiterbahn 46a eine Abzweigung 106, die zusammen mit dem Hauptstrang 108 hergestellt und ausgestanzt wurde, d.h. im Grunde genommen ein Teil der Folienleiterbahn 46a ist. Die Kontaktierung der Leitungen 101, 102, 103 mit den entsprechenden Leitungen 101, 102, 103 der Abzweigung 106 erfolgt auf herkömmliche Weise. Hierbei sind die Leitungen 101, 102 und 103 entsprechend der durch sie maximal zu übertragenden Leistung ausgelegt und ggf. elektrisch abgeschirmt.

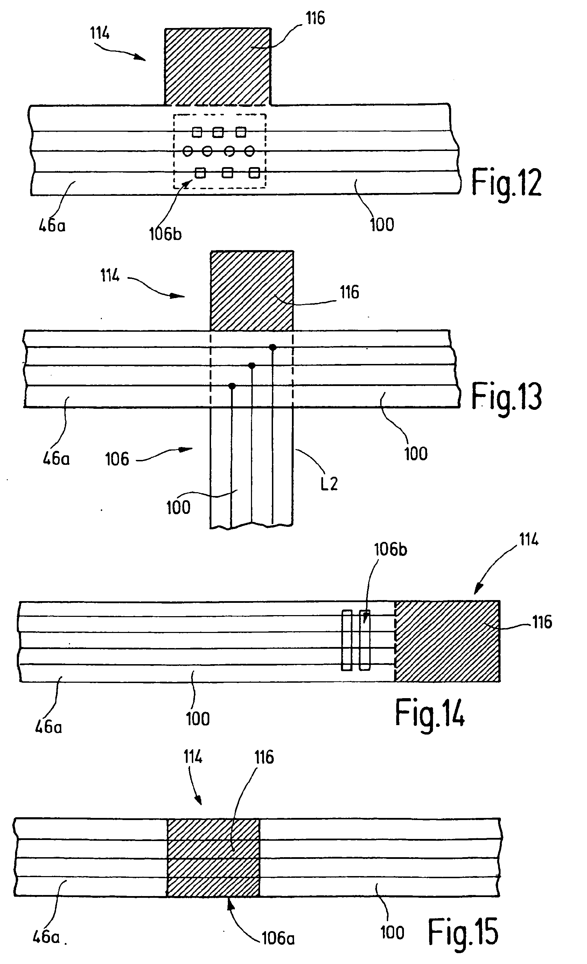

Anstelle der Folienleiterbahn 46a mit der Abzweigung 106, wie in Fig. 8 dargestellt, kann auch eine Folienleiterbahn 46a in Form einer laminierten FFC (flexible flat cable) oder alternativ auch einer extrudierten FFC verwendet werden, wobei in diesen Fällen, wie auch bei der Verwendung eines herkömmlichen Rundleiters 46b, die Abzweigungen 106 bzw. Verbindungen 106a nachträglich angebracht werden müssen. Beispiele für derartige Ausführungsformen sind in den Figuren 9 bis 11 dargestellt. Hierbei zeigt Fig. 9 eine Abzweigung 106 von einer FFC zu einer FPC 100, Fig. 10 eine Abzweigung 106 von einer FPC 100 zu einer FPC 100 und Fig. 11 eine Verbindung 106a von einem herkömmlichen Rundleiter zu einer FPC 100. Die FPCs 100 sind jeweils mit einer Schaltung 112 bestückt und mit einem Aktor, bspw. dem Schrittverstellmotor 40, oder einem Sensor, bspw. dem Innenraumtemperaturfühler 66, verbunden, welcher durch die über die Leitung 46, d.h. die Leitungen 101, 102, 103, geleiteten Signale gesteuert und angetrieben wird bzw. dessen Daten abgefragt und an die entsprechende Steuerelektronik, bspw. die Steuerelektronik 44 oder die Gebläseleistungselektronik 48, zurückgeleitet werden.

Erfindungsgemäß sind Bereiche von Abzweigungen 106, Verbindungen 106a oder beispielsweise mit zusätzlichen Elementen 106b versehene Bereiche mittels einer Schutzvorrichtung 114 geschützt. Diese Schutzvorrichtung 114 dient neben dem Schutz vor Umgebungseinflüssen, wie Feuchtigkeit oder Schmutz, gleichzeitig der Zugentlastung. Hierbei werden die meist dreilagig (Trägermaterial, Leitermaterial, Deckschicht) ausgebildeten Folienleiterbahnen 46a im jeweiligen Bereich durch die Schutzvorrichtung 114 in Form einer Abdeckung 116 überdeckt, wie in den Figuren 12 bis 16 in verschiedenen Ausführungsformen dargestellt ist.

Die Abdeckung 116 kann durch einen seitlich abstehenden Teil der Deckschicht der FPC 100, wie in Fig. 12 dargestellt, gebildet werden, welcher nach dem Anbringen der zusätzlichen Elemente 106b, insbesondere von elektrischen Bauteilen, umgeschlagen wird, so dass er den zu schützenden Bereich abdeckt. Die Abdeckung 116 kann nach dem Umschlagen mittels Crimpen, Piercen, Kleben, Löten, Schweißen oder Siegeln mit der Deckschicht und/oder dem Trägermaterial der FPC 100 verbunden werden.

Gemäß der in Fig. 13 dargestellten Ausführungsform wird die Abdeckung 116 der Abzweigung 106 einer FPC 100 von einer weiterführenden FPC 100 durch einen Teil des Trägermaterials der abzweigenden FPC 100 gebildet, welcher entsprechend der vorstehend beschriebenen Ausführungsform umgeschlagen und mit der Deckschicht und/oder dem Trägermaterial der anderen FPC 100 verbunden wird.

In Fig. 14 ist eine Variante für die Abdeckung von elektrischen Bauteilen am Anfang oder am Ende einer FPC 100 dargestellt. Hierbei ist die Folie, das Trägermaterial oder die Deckschicht der FPC 100 über den zu schützenden Bereich, in dem bspw. Elemente 106b angeordnet sind, hinaus verlängert, so dass beim Umschlagen des verlängerten Bereichs, welcher die Abdekkung 116 bildet, der zu schützende Bereich vollständig überdeckt ist. Die Abdeckung 116 kann mittels der zuvor beschriebenen Verfahren befestigt werden.

Fig. 15 zeigt die Abdeckung 116 einer Verbindung 106a zweier FPCs 100, welche im wesentlichen der in Fig. 12 dargestellten Ausführungsform entspricht. Hierfür wird bei jeder FPC 100 das Trägermaterial so weit von der Deckschicht geteilt, dass beim Überlappen der gesamte abzudeckende und zu schützende Bereich ausreichend abgedeckt ist. Die beiden FPCs 100 können mittels der zuvor beschriebenen Verfahren miteinander verbunden werden.

Fig. 16 eine weitere Variante, gemäß der die Abdeckung 116 durch ein separates Teil gebildet wird, welches auf dem entsprechenden Bereich der FPC 100 angebracht wird. Hierbei kann die Abdeckung 116 beispielsweise aus einem dem Trägermaterial oder der Deckschicht entsprechenden Material bestehen und mittels der zuvor beschriebenen Verfahren befestigt werden. Alternativ wäre ein Umwickeln möglich.

Die Befestigung der Folienleiterbahnen 46a kann - neben der Befestigung mittels Kleben - mit Hilfe der zuvor genannten Verbindungsvorrichtung 110 erfolgen, wie in Fig. 17 dargestellt. Hierfür sind am Grundkörper, d.h. im vorliegenden Fall am Luftführungsgehäuse 12 der Klimaanlage, Vorsprünge 120 vorgesehen und die Folienleiterbahnen 46a weisen Öffnungen 122 auf, welche einen etwas geringeren Durchmesser als die Vorsprünge 120 haben.

Bei der Montage werden die Vorsprünge 120 auf dem Luftführungsgehäuse 12 durch die Öffnungen 122 in der Folienleiterbahn 46a geschoben, wodurch sie infolge von Reibungskräften lösbar fixiert sind. Alternativ sind auch Vorsprünge mit Hinterschneidungen möglich. Zur einfacheren und exakteren Positionierung der Folienleiterbahn 46a am Luftführungsgehäuse 12 sind Strukturen auf der Oberfläche des Luftführungsgehäuses 12 in Form von als Anschlägen dienenden Rändern 124 vorgesehen, die bei der Anbringung der Folienleiterbahn 46a am Luftführungsgehäuse 12 in Anlage an die beiden in Längsrichtung verlaufenden Ränder 126 der Folienleiterbahn 46a gelangen.

Soll eine exakte Positionierung der Folienleiterbahnen 46a auf dem Grundkörper erfolgen, so können die Vorsprünge und Öffnungen richtungsorientierte Formen, beispielsweise eine etwa dreieckförmige Gestalt, haben. Ferner kann der Abstand zwischen benachbarten Vorsprüngen bzw. Öffnungen variieren, so dass nur eine Position möglich ist. Ebenfalls sind andere Markierungen, wie bspw. Farbmarkierungen, zur Erleichterung der richtigen Positionierung möglich.

Ferner können entsprechende Verbindungsvorrichtungen 110 auch in anderen Bereichen der Klimaanlage 10 angeordnet sein.

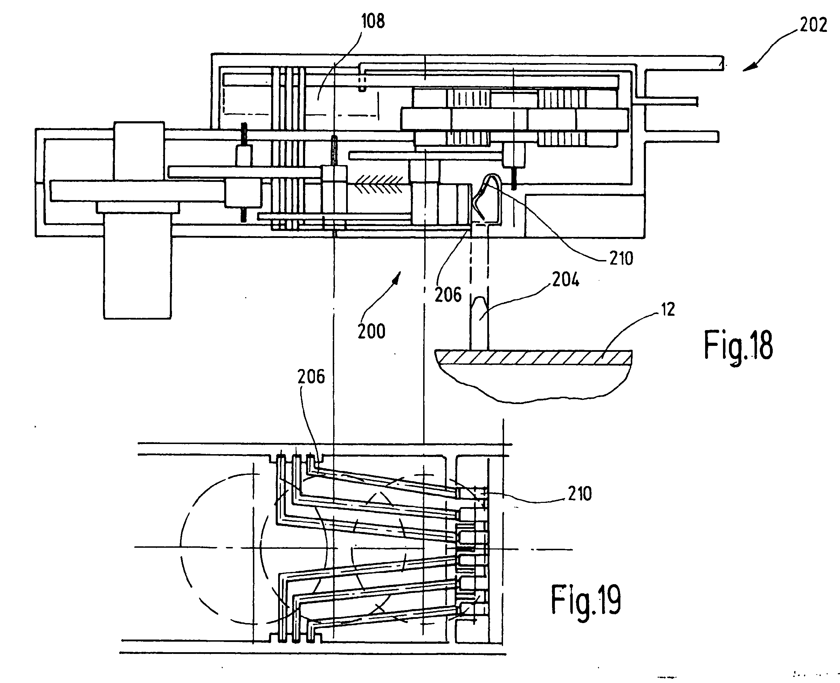

Alternativ zu den zuvor genannten Verbindungen zwischen den Leitungen 46 und den Aktoren 40, 42 usw., bei dem eine direkte Kontaktierung beim Einstecken in das Gehäuse 12 erfolgt und die Adressierung durch die Stekker, bspw. durch die Ausgestaltung der Stecker, fest vorgegeben ist, kann ein flexibles, anpassungsfähiges Adressierungssystem 200 verwendet werden. Ein Beispiel hierfür ist im folgenden unter Bezugnahme auf die Figuren 18 und 19 beschrieben.

Fig. 18 zeigt einen Querschnitt durch ein anpassungsfähiges Codier- oder Adressierungssystem 200, das mit Steckern ohne Steckersonderformen für die Adresse auskommt, sondern mit Hilfe einer einzigen dreipoligen Standard-Steckverbindung 202 die Stromversorgung und die Weiterleitung von Informationen (Bussystem) ermöglicht. Für die Codierung sind Codiervorsprünge oder -stege 204 vorgesehen, die am Gehäuse 12 oder aber an anderen Stellen der Klimaanlage 10 angespritzt sind, und welche mit Kontaktbahnen 206 zusammenwirken. Die Kontaktbahnen 206 sind ihrerseits mit einer elektrischen Steuerung 208 verbunden und an ihrem einen Ende derart ausgebildet, dass sie in Aussparungen und - im eingesteckten Zustand - parallel zu den Codierstegen 204 verlaufen. Zur Bildung eines elektrischen Kontakts sind elastisch verformbare Kontaktzungen 210 vorgesehen, welche im Ausgangszustand an den Kontaktbahnen 206 anliegen, durch die Codierstege 204 jedoch außer Kontakt gelangen sofern an der entsprechenden Stelle ein Codiersteg 204 vorhanden ist, wodurch die gleichen Stecker verwendet werden können.

Die Verwendung des oben genannten Adressierungssystems 200 beschränkt sich nicht auf Folienleiterbahnen. Eine Verwendung für andere Leiter, bspw. für Rundleiter, ist ebenfalls möglich.

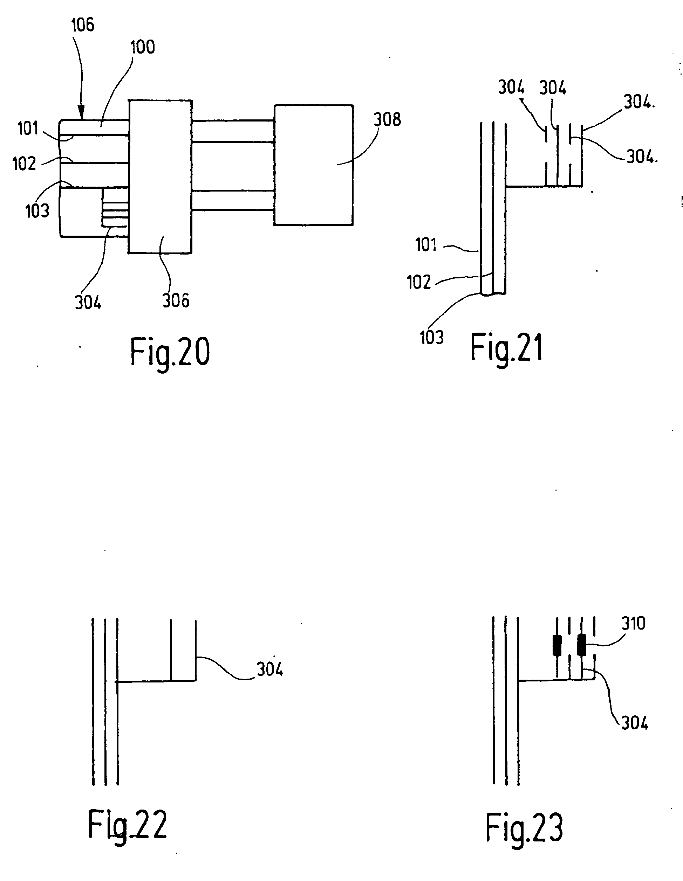

Gemäß einer weiterentwickelten, alternativen Ausführungsform erfolgt die Adressierung der Busteilnehmer 308 über ein anderes Codier- oder Adressierungssystem 300. Hierbei wird, ausgehend von dem dreiadrigen Hauptstrang 108, wobei die Leitungen 101, 102 und 103 die Plus-, Daten- bzw. Masse-Leitung für Busteilnehmer 308 bilden, je Busteilnehmer 308 eine entsprechende dreiadrige Leitung abgezweigt, wie es bspw. in Fig. 8 dargestellt ist. Die abzweigende Leitung ist hierbei eine FPC 100, der Hauptstrang 108 kann beispielsweise eine Folienleiterbahn 46a oder ein konventioneller Rundleiter 46b sein. Auf der FPC 100 ist - neben den drei Leitungen 101, 102, 103- eine Anzahl von Adressleitungen 304 abgebildet, welche auf eine nachfolgend beschriebene Weise selektiv mit der Masse-Leitung verbunden sind. Je nach der Komplexität des Systems, d.h. wie viele Busteilnehmer angesprochen werden müssen, bestimmt sich die Zahl der Adressleitungen 304. So können bspw. mit n=4 Adressleitungen 304, wie in Fig. 20 dargestellt, maximal 2ⁿ=16 Busteilnehmer angesprochen werden. Die Leitungen 101, 102, 103 sowie die Adressleitungen 304 führen zu einer Steuerungsschaltung 306 des entsprechenden Busteilnehmers 308. Im vorliegenden Fall handelt es sich beim Busteilnehmer 308 um einen Schrittverstellmotor mit zwei Spulenpaaren, so dass vier Anschlüsse erforderlich sind, welche von der Steuerungsschaltung 306 zum Busteilnehmer 308 abgehen. Die Kontaktierung des Busteilnehmers 308 kann, wie dargestellt, direkt oder aber über Steckkontakte erfolgen.

Für die Codierung werden die Adressleitungen entsprechend geschaltet, wobei die unterbrochenen Leitungen mit log 0 und die durchgehenden Leitungen mit log 1 bewertet werden. Für die Schaltung gibt es verschiedene Möglichkeiten. Gemäß einer ersten, in Fig. 21 dargestellten Variante werden alle Adressleitungen 304 auf der Folienleiterbahn der Abzweigung abgebildet und die mit log 0 bewerteten Leitungen unterbrochen, was bspw. mittels Stanzen, Fräsen, Brennen erfolgen kann. Gemäß einer zweiten Variante, die in Fig. 22 dargestellt ist, werden nur die zur Codierung erforderlichen Leitungen auf der Folienleiterbahn der Abzweigung abgebildet. Gemäß einer dritten, in Fig. 23 dargestellten Variante werden die Adressleitungen in unterbrochener Form auf der Folienleiterbahn der Abzweigung abgebildet und die mit log 1 bewerteten Adressleitungen mittels Brücken geschlossen. Hierfür werden 0-Ohm-Widerstände 310 (Jumper) oder für die Schaltung benötigte Bauteile (z.B. Diode) verwendet.

### Bezugszeichenliste

- 10: Klimaanlage
- 12: Luftführungsgehäuse
- 14: Gebläse
- 14a: Gebläseregler
- 16: Gebläsegehäuse 16
- 18: Luftansaugtrakt
- 20: Gebläsemotorhalter
- 22: Filtergehäuse
- 24: Lufttemperiergehäuse
- 26: Verdampfer
- 28: Heizkörper
- 30: Luftverteilgehäuse
- 32, 34, 36, 38: Luftauslass
- 40,: 42 Schrittverstellmotor, Aktor
- 44: Steuerelektronik
- 46: Leitung
- 46a: Folienleiterbahn
- 48: Gebläseleistungselektronik
- 50: Leistungstransistor
- 52: Nebenluftansaugkanal
- 54: Gebläsemotor
- 60: Außentemperaturfühler
- 62: Kühlmitteltemperaturfühler
- 64: Fahrgeschwindigkeitsmesser
- 66: Innenraumtemperaturfühler
- 68: Solarsensor
- 70: Multifunktionssensor, Schadstoffsensor
- 72: Aktor
- 76: Aktor
- 78: Filterklappe
- 80: Bedieneinheit
- 82: Verdampfertemperatursensor
- 84: Druck- und Temperaturgeber
- 86: Batteriespannungssensor
- 88: Motordrehzahlgeber
- 90: Kältemittelverdichter
- 92: Expansionsventil
- 94: Lüfter
- 96: Aktor
- 98: Luftmischklappe
- 100: FPC
- 101, 102, 103: Leitung
- 106: Abzweigung
- 106a: Verbindung
- 106b: Element
- 108: Hauptstrang
- 110: Verbindungsvorrichtung
- 112: Schaltung
- 114: Schutzvorrichtung
- 116: Abdeckung
- 120: Vorsprung
- 122: Öffnung
- 124: Rand (Struktur auf Gehäuse 12)
- 126: Rand (Folienleiterbahn)
- 200: Adressierungssystem
- 202: Standard-Steckverbindung
- 204: Codiersteg
- 206: Kontaktbahn
- 208: elektrische Steuerung
- 210: Kontaktzunge
- 300: Adressierungssystem
- 304: Adressleitung
- 306: Steuerungsschaltung
- 308: Busteilnehmer
- 310: 0-Ohm-Widerstand

## Patentansprüche

1. Heizungs- oder Klimaanlage für ein Kraftfahrzeug mit einem Luftführungsgehäuse, in und/oder an dem Komponenten der Anlage angeordnet sind, wobei die Komponenten Gebläse, gegebenenfalls Filter, wenigstens einen Wärmetauscher, Luftstromsteuerelemente, Aktoren und gegebenenfalls Sensoren umfassen und mit einer Steuerelektronik, in die von einer Bedieneinheit Steuersignale eingebbar sind und die Steuerelektronik über elektrische Leitungen mit wenigstens einigen der Komponenten der Anlage verbunden ist, wobei zumindest ein Teil der elektrischen Leitungen (46) durch eine oder mehrere Folienleiterbahnen (46a) gebildet wird und eine Folienleiterbahn (46a) mindestens eine Leitung (101, 102, 103) aufweist, **dadurch gekennzeichnet, dass** die Heizungs- oder Klimaanlage (10) ein Adressierungssystem (200; 300) in Form einer FPC (100) aufweist.

2. Anlage nach Anspruch 1, **dadurch gekennzeichnet, daß** eine Folienleiterbahn eine Mehrzahl von Leitungen, wie insbesondere zwei, drei, vier, fünf oder mehr Leitungen aufweist.

3. Anlage nach Anspruch 1 oder 2, **dadurch gekennzeichnet, dass** die Folienleiterbahn (46a) drei Leitungen (101, 102, 103) aufweist, wobei eine Leitung (101) eine Plus-Leitung, eine Leitung (102) eine Daten-Leitung und eine Leitung (103) eine Masse-Leitung ist.

4. Anlage nach Anspruch 1, 2 oder 3, **dadurch gekennzeichnet, dass** ein Hauptstrang (108) der elektrischen Leitung (46) mindestens eine Abzweigung (106) und/oder eine Verbindung (106a) aufweist.

5. Anlage nach Anspruch 4, **dadurch gekennzeichnet, dass** die Abzweigung (106) drei Leitungen (101, 102, 103) aufweist, die jeweils mit einer Leitung (101, 102, 103) des Hauptstranges (108) verbunden sind.

6. Anlage nach Anspruch 4 oder 5, **dadurch gekennzeichnet, dass** nach der Abzweigung (106) mindestens ein Busteilnehmer (308) angeordnet ist.

7. Anlage nach einem der vorhergehenden Ansprüche, **dadurch gekennzeichnet, dass** die Folienleiterbahn (46a) eine FPC (100) ist.

8. Anlage nach einem der vorhergehenden Ansprüche, **dadurch gekennzeichnet, dass** die Folienleiterbahn (46a) eine Schutzvorrichtung (114) aufweist.

9. Anlage nach Anspruch 8, **dadurch gekennzeichnet, dass** die Schutzvorrichtung (114) eine Abdeckung (116) umfasst, die zumindest einen Bereich der Folienleiterbahn (46a) überdeckt.

10. Anlage nach Anspruch 8 oder 9, **dadurch gekennzeichnet, dass** die Schutzvorrichtung (114) durch einen Teil der Folienleiterbahn (46a) gebildet ist.

11. Anlage nach Anspruch 10, **dadurch gekennzeichnet, dass** der die Schutzvorrichtung (114) bildende Teil der Folienleiterbahn (46a) aus einem im Ausgangszustand seitlich oder in Längsrichtung überstehenden Teil der Folienleiterbahn (46a) gebildet ist, der umgeschlagen und an der Folienleiterbahn (46a) befestigt ist.

12. Anlage nach einem der Ansprüche 8 bis 11, **dadurch gekennzeichnet, dass** die Schutzvorrichtung (114) im Bereich einer Abzweigung (106), einer Verbindung (106a) oder in einem mit mindestens einem zusätzlichen Element (106b) versehenen Bereich vorgesehen ist.

13. Anlage nach einem der vorhergehenden Ansprüche, **dadurch gekennzeichnet, dass** eine Verbindungsvorrichtung (110) vorgesehen ist.

14. Anlage nach Anspruch 13, **dadurch gekennzeichnet, dass** die Verbindungsvorrichtung (110) Vorsprünge (120) aufweist, die mit Öffnungen (122) zusammenwirken.

15. Anlage nach Anspruch 14, **dadurch gekennzeichnet, dass** die Vorsprünge (120) an einem Gehäuse (12) und die Öffnungen (122) in der Folienleiterbahn (46a) vorgesehen sind.

16. Anlage nach einem der Ansprüche 13 bis 15, **dadurch gekennzeichnet, dass** die Folienleiterbahn (46a) mittels einer Verbindungsvorrichtung (110) am Luftführungsgehäuse (12) positioniert lösbar befestigt ist, wobei die Verbindungsvorrichtung (110) Mittel (120, 122) zur Positionierung aufweist.

17. Anlage nach einem der vorhergehenden Ansprüche, **dadurch gekennzeichnet, dass** die das Adressierungssystem (200) einen Stecker aufweist, der mit Codierelementen (204) zusammenwirkt, die außerhalb des Steckers vorgesehen sind.

18. Anlage nach einem der vorhergehenden Ansprüche, **dadurch gekennzeichnet, dass** die Codierelemente (204) einen elektrischen Kontakt (206, 210) unterbrechen.

19. Anlage nach einem nach einem der vorhergehenden Ansprüche, **dadurch gekennzeichnet, dass** das Adressierungssystem (200; 300) n Adressleitungen (304) aufweist, wobei die Zahl der maximalen Bustellnehmer (308) in einem System 2ⁿ ist.

## Claims

1. A heating or cooling device for a motor vehicle having an air conduction housing in and/or on which are positioned components of the device, said components comprising a fan, where appropriate a filter, at least one heat exchanger, air flow control elements, actuators and where appropriate sensors, and having an electronic control system into which it is possible to input control signals from an operating unit, it being possible to connect the electronic control system to at least some components of the device by means of electrical wires, at least some of said electrical wires (46) taking the form of one or more flexible flat cables (46a), and one flexible flat cable (46a) having at least one wire (101, 102, 103),
**characterised in that**
the heating or cooling device (10) has an addressing system (200; 300) in the form of an FPC (100).

2. A device in accordance with claim 1,
**characterised in that**
a flexible flat cable has a multiplicity of wires such as, in particular, two, three, four, five or more wires.

3. A device in accordance with claim 1 or 2,
**characterised in that**
the flexible flat cable (46a) has three wires (101, 102, 103), one wire (101) being a positive wire, one wire (102) being a data wire and one wire (103) being an earth wire.

4. A device in accordance with claim 1, 2 or 3,
**characterised in that**
a main strand (108) of the electrical wire (46) has at least one branch (106) and/or one connection (106a).

5. A device in accordance with claim 4,
**characterised in that**
the branch (106) has three wires (101, 102, 103) which are each connected to a wire (101, 102, 103) in the main strand (108).

6. A device in accordance with claim 4 or 5,
**characterised in that**
at least one bus node (308) is positioned downstream of the branch (106).

7. A device in accordance with one of the preceding claims,
**characterised in that**
the flexible flat cable (46a) is an FPC (100).

8. A device in accordance with one of the preceding claims,
**characterised in that**
the flexible flat cable (46a) has a protective device (114).

9. A device in accordance with claim 8,
**characterised in that**
the protective device (114) comprises a cover (116) which covers at least one area of the flexible flat cable (46a).

10. A device in accordance with claim 8 or 9,
**characterised in that**
the protective device (114) is formed by part of the flexible flat cable (46a).

11. A device in accordance with claim 10,
**characterised in that**
the part of the flexible flat cable (46a) forming the protective device (114) takes the form of a part of the flexible flat cable (46a) which originally projects laterally or longitudinally and which is folded down and fixed to the flexible flat cable (46a).

12. A device in accordance with one of claims 8 to 11,
**characterised in that**
the protective device (114) is provided in the area of a branch (106) or a connection (106a) or in an area with at least one additional element (106b).

13. A device in accordance with one of the preceding claims,
**characterised in that**
a connecting device (110) is provided.

14. A process in accordance with claim 13,
**characterised in that**
the connecting device (110) has projections (120) which co-operate with openings (122).

15. A device in accordance with claim 14,
**characterised in that**
the projections (120) are provided on a housing (12) and the openings (122) are provided in the flexible flat cable (46a).

16. A device in accordance with one of claims 13 to 15,
**characterised in that**
the flexible flat cable (46a) is positioned on the air conduction housing (12) and fixed by means of a connecting device (110) in such a manner that it can be detached, the connecting device (110) having positioning means (120, 122).

17. A device in accordance with one of the preceding claims,
**characterised in that**
the addressing system (200) has a plug which co-operates with coding elements (204) which are provided outside the plug.

18. A device in accordance with one of the preceding claims,
**characterised in that**
the coding elements (204) break an electrical contact (206, 210).

19. A device in accordance with one of the preceding claims,
**characterised in that**
the addressing system (220; 300) has n address lines (304), the maximum number of bus nodes (308) in a system being 2ⁿ.

## Revendications

1. Système de chauffage ou de climatisation pour un véhicule automobile, comprenant un carter de passage d'air dans et/ou sur lequel sont disposés des composants du système, où les composants comprennent un ventilateur, le cas échéant des filtres, au moins un échangeur de chaleur, des éléments de commande du flux d'air, des actionneurs et, le cas échéant, des capteurs, et comprenant une électronique de commande à laquelle des signaux de commande peuvent être fournis par une unité de commande, et l'électronique de commande, via des circuits électriques, est connectée à au moins quelques-uns des composants du système, où au moins une partie des circuits électriques (46) est formée par un ou plusieurs circuits conducteurs en feuille mince (46a), et un circuit conducteur en feuille mince (46a) présente au moins un circuit (101, 102, 103), **caractérisé en ce que** le système de chauffage ou de climatisation (10) présente un système d'adressage (200 ; 300) sous la forme d'un circuit imprimé flexible - FPC - (100).

2. Système selon la revendication 1, **caractérisé en ce qu'**un circuit conducteur en feuille mince présente une pluralité de circuits, en particulier deux, trois, quatre, cinq circuits ou plus.

3. Système selon la revendication 1 ou 2, **caractérisé en ce que** le circuit conducteur en feuille mince (46a) présente trois circuits (101, 102, 103), où un circuit (101) est un circuit positif, un circuit (102) est un circuit de données et un circuit (103) est un circuit à la masse.

4. Système selon les revendications 1, 2 ou 3, **caractérisé en ce qu'**une branche principale (108) du circuit électrique (46) présente au moins une dérivation (106) et/ou une connexion (106a).

5. Système selon la revendication 4, **caractérisé en ce que** la dérivation (106) présente trois circuits (101, 102, 103) qui sont connectés, respectivement, à un circuit (101, 102, 103) de la branche principale (108).

6. Système selon la revendication 4 ou 5, **caractérisé en ce que** au moins un bus d'utilisateur (308) est disposé en aval de la dérivation (106).

7. Système selon l'une quelconque des revendications précédentes, **caractérisé en ce que** le circuit conducteur en feuille mince (46a) est un circuit imprimé flexible - FPC - (100).

8. Système selon l'une quelconque des revendications précédentes, **caractérisé en ce que** le circuit conducteur en feuille mince (46a) présente un dispositif de protection (114).

9. Système selon la revendication 8, **caractérisé en ce que** le dispositif de protection (114) comprend un recouvrement (116) qui recouvre au moins une zone du circuit conducteur en feuille mince (46a).

10. Système selon la revendication 8 ou 9, **caractérisé en ce que** le dispositif de protection (114) est formé par une partie du circuit conducteur en feuille mince (46a).

11. Système selon la revendication 10, **caractérisé en ce que** la partie du circuit conducteur en feuille mince (46a) formant le dispositif de protection (114) est formée par une partie du circuit conducteur en feuille mince (46a) dépassant, à l'état initial, latéralement ou dans la direction longitudinale, laquelle partie du circuit conducteur en feuille mince est rabattue et fixée sur le circuit conducteur en feuille mince (46a).

12. Système selon l'une quelconque des revendications 8 à 11, **caractérisé en ce que** le dispositif de protection (114) est prévu dans la zone d'une dérivation (106), d'une connexion (106a) ou bien dans une zone dotée d'au moins un élément supplémentaire (106b).

13. Système selon l'une quelconque des revendications précédentes, **caractérisé en ce qu'**il est prévu un dispositif d'assemblage (110).

14. Système selon la revendication 13, **caractérisé en ce que** le dispositif d'assemblage (110) présente des parties saillantes (120) qui agissent de façon conjointe avec des ouvertures (122).

15. Système selon la revendication 14, **caractérisé en ce que** les parties saillantes (120) sont prévues sur un carter (12), les ouvertures (122) étant prévues dans le circuit conducteur en feuille mince (46a).

16. Système selon l'une quelconque des revendications 13 à 15, **caractérisé en ce que** le circuit conducteur en feuille mince (46a), positionné sur le carter de passage d'air (12) au moyen d'un dispositif d'assemblage (110), est fixé de façon détachable, le dispositif d'assemblage (110) présentant des moyens de positionnement (120, 122).

17. Système selon l'une quelconque des revendications précédentes, **caractérisé en ce que** le système d'adressage (200) présente une fiche mâle qui agit conjointement avec des éléments de codage (204) qui sont prévus à l'extérieur de la fiche mâle.

18. Système selon l'une quelconque des revendications précédentes, **caractérisé en ce que** les éléments de codage (204) interrompent un contact électrique (206, 210).

19. Système selon l'une quelconque des revendications précédentes, **caractérisé en ce que** le système d'adressage (200, 300) présente n circuits d'adresses (304), le nombre maximum d'utilisateurs de bus (308) dans un système étant égal à 2ⁿ.
